# EUROPEAN PATENT SPECIFICATION

(11) **EP 4 128 383 B1**
(45) Date of publication and mention of the grant of the patent: **08.01.2025**
(21) Application number: 21709995.1
(22) Date of filing: 09.03.2021
(51) Int. Cl.: H10K 10/20, H10K 10/82, H10K 77/10

(54) **FLEXIBLE AND LIGHTWEIGHT DIODE AND ITS PROCESS OF MANUFACTURING**
FLEXIBLE UND LEICHTE DIODE UND VERFAHREN ZU IHRER HERSTELLUNG
DIODE FLEXIBLE ET LÉGÈRE ET SON PROCÉDÉ DE FABRICATION

(30) Priority: 23.03.2020 EP 20382214
(43) Date of publication of application: 08.02.2023
(73) Proprietor: Consejo Superior de Investigaciones Científicas (CSIC), 28006 Madrid (ES); Universitat de Girona, 17004 Girona (ES); Universidade Do Algarve, 8005-139 Faro, Algarve (PT); Instituto de Telecomunicações, 3810-193 Aveiro (PT)
(72) Inventor: MARTÍNEZ-DOMINGO, Carme, 08193 Cerdanyola del Vallès -Bellaterra ( Barcelona) (ES); CONTI, Silvia, 08193 Cerdanyola del Vallès - Bellaterra ( Barcelona) (ES); TERÉS TERÉS, Lluís, 08193 Cerdanyola del Vallès - Bellaterra ( Barcelona) (ES); RAMON GARCIA, Eloi, 08193 Cerdanyola del Vallès - Bellaterra ( Barcelona) (ES); VILASECA MORERA, Fabiola, 17820 Banyoles (GIRONA) (ES); LEONEL GOMES, Henrique, 8005-139 Faro, Algarve (PT)
(74) Representative: Pons
(86) International application number: PCT/EP2021/055927
(87) International publication number: WO 2021/190916

(56) References cited:
- US-A1- 2007 096 080
- CARME MARTÍNEZ-DOMINGO ET AL: "Novel flexible inkjet-printed Metal-Insulator-Semiconductor organic diode employing silver electrodes", ORGANIC ELECTRONICS, vol. 62, 7 August 2018 (2018-08-07), NL, pages 335 - 341, XP055728255, ISSN: 1566-1199, DOI: 10.1016/j.orgel.2018.08.011
- GUSTAV NYSTROM ET AL: "A Nanocellulose Polypyrrole Composite Based on Microfibrillated Cellulose from Wood", THE JOURNAL OF PHYSICAL CHEMISTRY B, vol. 114, no. 12, 5 March 2010 (2010-03-05), pages 4178 - 4182, XP055027799, ISSN: 1520-6106, DOI: 10.1021/jp911272m

## Description

The invention relates to a flexible and lightweight diode susceptible of being processed by inkjet printing additive manufacturing, which is based on conductive nanopaper. Furthermore, the invention relates to its process of manufacturing by means of an additive manufacturing technique and to an electronic component comprising said diode.

Therefore, the present invention could be included in the field of paper-based green electronics.

### BACKGROUND ART

In recent years, studies have been intensely made to develop organic and flexible diodes in which polymeric functional materials and temperature sensitive substrates such as plastic foils are employed.

As a matter of definition herein, a diode is a semiconductor device characterized by a rectifying interface which blocks or allows the current through it depending on the applied bias. It can be fabricated using broad architectures and organic materials processed from solution. Typical diode architectures are based on P-N or Schottky junctions where p-type/n-type organic semiconductor (OSC) or metal/OSC are the rectifying interfaces, respectively. P-N junctions require the use of two kinds of semiconductors with different type of majority charge carriers and to align the electrodes Work Function (WF) to the P-N semiconductor WF to obtain the formation of ohmic contacts. It should be further noted that the inherent diffusion of the majority charge carriers provokes a built-in potential of typically 0.7eV, thereby the devices start to operate above this potential.

As a consequence, considering:
- the lack of electrical stability of n-type OSCs,
- the need to control and balance the level of dopants of each semiconductor in P-N junctions,
- the need to align the electrodes WF to the P-N semiconductor WF to obtain the formation of ohmic contacts,
the implementation of inkjet organic diodes based on P-N junctions is still challenging. A more commonly employed architecture for the fabrication of organic diodes is the Schottky junction, which is based on ohmic electrode/OSC/rectifying electrode stack. Nevertheless, it is known that this structure presents challenges since the rectifying interface results from the contact between the OSC and specific WF electrodes. The two electrodes are chosen according to the alignment between their WFs and the OSC energy levels. One of the electrodes WFs must be aligned with the OSC WF to obtain an ohmic contact, whereas the other must be misaligned to obtain a rectifying interface. This limitation affects the natural progress of these devices in the field of organic electronics.

The development of solution-based electronic components offers the possibility to manufacture flexible and lightweight electronics using additive processes. Inkjet printing, in particular, has been receiving growing interest as a method for the deposition of functional materials, as opposed to more conventional approaches. Although this technique has been widely used for the fabrication of flexible organic devices, so far, a simple diode still remains a challenge for the technology.

To date, the related art has failed to effectively fabricate an organic Schottky diode using polymeric materials by means of inkjet printing onto temperature sensitive substrates. The low availability of solution-based metals with uneven WFs required to obtain a rectifier interface, hampers the implementation of diodes into large area manufacturing such as additive fabrication techniques. Although few metallic inks are commercially available and feature these characteristics, these materials often need the application of aggressive post-treatments, such as intense pulsed light (IPL) sintering or high curing temperatures among others, making them incompatible with OSCs and temperature sensitive substrates, as plastic or cellulose substrates. Evaporation and sputtering are still the most common techniques for the deposition of metal electrodes in the fabrication of organic diodes.

Accordingly, Martinez Domingo, C. et al. "Novel flexible inkjet-printed Metal-Insulator-Semiconductor organic diode employing silver electrodes", Organic Electronics 2018, 62, pg. 335-341 describes a diode susceptible of being processed by inkjet printing additive manufacturing comprising printing a first layer onto the conductive substrate by means of an additive, drop casting of a second layer onto the cured product obtained before and drop casting of a third layer onto the cured product further obtained before. Nystrom, G. et al. "A Nanocellulose Polypyrrole Composite Based on Microfibrillated Cellulose from Wood", The Journal of Physical Chemistry B, 2010, 114(12), pg. 4178-4182 describes a conductive substrate comprising a conductive nanopaper with cellulose nanofibers in a weight percent of 60 wt% and a conductive material ("PPy") in a weight percent of 40 wt% with respect to the total weight of the conductive substrate, said conductive material being a conductive polymer.

All these requirements make difficult a rapid implementation of organic diodes into real applications; therefore, it would be advantageous to overcome these limitations. Another aspect that has to be taken into account is that, in semiconductor devices, especially flexible organic diodes, a substantial portion of non-biodegradable solid waste is represented by plastic substrates.

Thus, it is needed to develop novel diodes that are able to face and overcome all the issues presented so far.

### SUMMARY OF THE INVENTION

The invention refers to a flexible and lightweight diode, which can be included within the term paper-based green electronics. The diode of the present invention is based on a conductive nanopaper being therefore a sustainable, biodegradable and eco-friendly electronic component. In the diode of the present invention the conductive nanopaper is acting as both, substrate and cathode.

The first aspect of the present invention refers to a diode (herein "the diode of the present invention") susceptible of being processed by inkjet printing additive manufacturing characterized in that it comprises:
- a conductive substrate comprising a conductive nanopaper, said conductive nanopaper comprising:
   ∘ cellulose nanofibers in a weight percent of between 50 wt% and 80 wt% with respect to the total weight of the conductive substrate, and
   ∘ a conductive material in a weight percent of between 20 wt% and 50 wt% with respect to the total weight of the conductive substrate, said conductive material selected from a conductive polymer, carbon nanotubes or a combination thereof,
   and wherein the thickness of said conductive substrate (1) is ranging between 20 µm and 200 µm,
- a first layer comprising a polymeric insulator located onto the substrate, wherein the thickness of said first layer (2) is ranging between 500 nm and 1 µm, wherein the polymeric insulator is a cured ink comprising amorphous silica, epoxy resin and epoxy hardener,
- a second layer comprising an organic p-type semiconductor (OSC) located onto the first layer, wherein the thickness of said second layer is ranging between 200 nm and 500 nm,
- a third layer located onto the second layer, wherein the thickness of said third layer is ranging between 100 nm and 200 nm,
and wherein the conductive substrate is acting as cathode and the third layer is acting as the anode.

The diode of the present invention is characterized by a high mechanical response, with a tensile strength of about 200 MPa and Young's modulus of about 13 GPa; and it is flexible, which means that the substrate is foldable in around 180 degrees and the organic semiconductor can maintain its properties under a strain of up to 0.62%.

The diode of the present invention is lightweight, this means that its density is kept below 1.2 g cm⁻¹.

In the present invention the conductive nanopaper is acting as conductive substrate and as cathode, forming an ohmic contact with the first layer comprising a polymeric insulator.

The substrate of the present invention is a conductive substrate which, at the same time, holds the devices and acts as cathode, becoming an active component of the diode. This is possible thanks to the fact that the rectifying characteristic arises from the first layer of a polymeric insulator/second layer of organic p-type semiconductor interface (insulator/OSC interface), releasing the cathode from being responsible of the rectification.

The conductive substrate of the diode of the present invention is a conductive nanopaper comprising:
- cellulose nanofibers in a weight percent of between 50 wt% and 80 wt% with respect to the total weight of the conductive substrate (1), and
- a conductive material in a weight percent of between 20 wt% and 50 wt% with respect to the total weight of the conductive substrate (1), said conductive material selected from a conductive polymer, carbon nanotubes or a combination therof.

In a preferred embodiment of the diode of the present invention the conductive substrate consists of a conductive nanopaper, said conductive nanopaper consists of:
- cellulose nanofibers in a weight percent of between 50 wt% and 80 wt% with respect to the total weight of the conductive substrate, and
- a conductive material in a weight percent of between 20 wt% and 50 wt% with respect to the total weight of the conductive substrate, said conductive material selected from a conductive polymer, carbon nanotubes or a combination thereof,
wherein the sum of the percentages by weight is 100 wt%.

The proposed invention allows to skip the deposition of the cathode onto non-functional substrates and of an eventual additional planarization layer on the substrate, allowing a reduction in material, time, and cost consumption.

In a preferred embodiment of the diode of the present invention, the conductive polymer of the conductive substrate is selected from poly(3,4-ethylenedioxythiophene) polystyrene sulfonate (PEDOT:PSS) and polypyrrole (PPy).

The first layer of the diode of the present invention comprises a polymeric insulator which is an ink comprising amorphous silica, epoxy resin and epoxy hardener.

The second layer of the diode of the present invention comprises an organic p-type semiconductor (OSC). Preferably, the organic p-type semiconductor (OSC) of the second layer is poly(triaryl amine) (PTAA).

The third layer of the diode of the present invention is acting as anode.

In a preferred embodiment of the diode of the present invention, the third layer is a metal layer, wherein the metal is selected from Ag and Au.

In another preferred embodiment of the diode of the present invention the third layer is a polymeric layer of poly(3,4-ethylenedioxythiophene) polystyrene sulfonate (PEDOT:PSS).

As mentioned before, the interface between the first layer comprising a polymeric insulator and the second layer comprising an organic p-type semiconductor (insulator/OSC interface) is responsible for the rectifying characteristics of the diode of the present invention. The asymmetric characteristic of a diode is typically related to a change in its resistance, which is negligible in forward bias and high in reverse bias condition. OSCs usually favor only one type of carrier depending on the ease with which holes or electrons can be injected into said OSC from the electrodes.

Two different regimes of operation can be distinguished in the diode of the present invention: accumulation and depletion, defined according to the effect that the applied voltage has on the p-type OSC.

Under the application of a positive voltage to the hole transport p-type OSC semiconductor, free charges are injected and accumulated at the insulator/OSC interface (accumulation region). If a high conductance is registered across the insulator, the accumulation capacitance does not saturate, and a certain amount of current can pass through the insulator (forward bias).

Conversely, when a negative bias is applied to the organic p-type semiconductor (OSC), charges accumulate at the third layer (anode) electrode/ organic p-type semiconductor (OSC) interface. Thus, there is no charge at the polymeric insulator/ organic p-type semiconductor (OSC) interface, leaving only a space charge or depletion layer (reverse bias). The reverse leakage current and forward current give indications about the depletion region and accumulation region at the interface between the organic p-type semiconductor (OSC) and the polymeric insulator.

Therefore, one of the multiple advantages of the present diode is that the work function (WF) of the organic p-type semiconductor (OSC) and the polymeric insulator do not need to be aligned. The main requirement for the diode of the present invention comes from the leakage behaviour of the polymeric insulator. The polymeric insulator must be leaky enough to allow the current flow in forward bias, without leading to short-circuits. Since the majority of the organic p-type semiconductors (OSCs) present similar WFs compared to the ones of metallic inks, the formation of an ohmic contact at the OSC/electrode interface is totally feasible.

As stated before, the current flows through the diode of the present invention thanks to the presence of a leaky insulator. As it is known, the roughness of an underneath layer affects the quality and performance of the subsequent one. Based on that, conductive cellulose-based substrates are preferable candidates thanks to their higher roughnesses compared to common polymeric substrates. Whereas inkjet printed conductive electrodes (cathodes) onto the non-functional cellulose substrate would reduce the intrinsic and beneficial roughness of the cellulose, a substrate comprising a conductive polymer and cellulose nanofibers preserves the roughness needed to perturbate the good performance of the insulator. This feature is paramount to highlight because up to date rough substrates were detrimental for the correct operation of electronic devices.

In another preferred embodiment of the diode of the invention said diode is a diode-logic gate. Diode logic (DL) technology is the use of diodes to build Boolean logic gates. The most common application for DL is in Diode-Transistor Logic (DTL) integrated circuits. Diodes can perform switching and digital logic operations. Forward and reverse bias switch a diode between the low and high impedance states, respectively. So that it may serve as a switch. Logic Diodes can perform digital logic functions: "AND" and "OR".

The present invention also refers to the process for the manufacturing of the diode of the present invention (herein "the process of the invention") by inkjet printing additive manufacturing technique in which organic materials and nanoparticle-based materials are allowed in the form of solution. Said process comprises a step of printing the first layer comprising a polymeric insulator onto the conductive substrate comprising conductive nanopaper by means of an additive manufacturing technique, preferably by means of inkjet printing additive manufacturing technique.

Therefore, a second aspect of the present invention refers to a process for the manufacturing of a diode of the present invention described above, characterized in that it comprises the following steps:
a) printing the first layer onto the conductive substrate by means of an additive manufacturing technique, preferably by means of inkjet printing,
b) curing the product obtained in step (a), preferably by means of a hot plate,
c) drop casting of the second layer onto the cured product obtained in step (b),
d) curing the product obtained in step (c), preferably by means of a hot plate,
e) drop casting of the third layer onto the cured product obtained in step (d), and f) drying the product obtained in step (e) in air.

In a preferred embodiment of the process of the invention the conductive substrate of step (a) is obtained by following the next steps:
i) mixing a solution of cellulose nanofibers and a solution of a conductive material selected from a conductive polymer, carbon nanotubes or a combination thereof, wherein the weight percent of the cellulose nanofibers is ranging between 50 wt% and 80 wt% and the weight percent of the conductive material is ranging between 20 wt% and 50 wt% in the final mixture, and
ii) filtering the mixed solution obtained in step (i) under vacuum at a pressure ranging from 0.1 bar to 0.9 bar and at a temperature between 30 °C and 100 °C.

The last aspect of the present invention refers to an electronic component comprising the diode of the present invention described above. Therefore, the present diode of the invention can be part of integrated circuits or electronic systems as discrete device. Diodes along with other electronic components such as resistors, transistors, etc. can create electronic circuits with a particular function, as for example rectifiers, oscillators, among others.

### BRIEF DESCRIPTION OF THE DRAWINGS

**Figure 1****.** Scheme of the diode multilayered structure of the present invention (a). Optical images of the diode (b).
**Figure 2****.** Fabrication scheme of the diode structures (a). Optical (i) and SEM images (ii) of a fabricated diode (b).
**Figure 3****.** Electrical characterization of the diodes. I-V characteristics in linear scale (left axis) and semi-logarithmic scale (right axis) (a) Capacitance-Voltage (left axis) and Loss-Voltage (right axis) characteristics (b).

### Examples

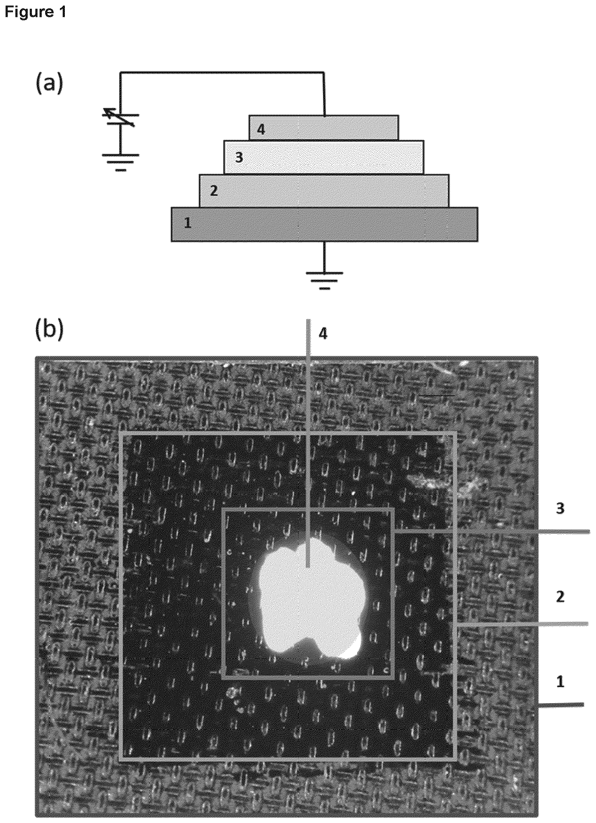

Figure 1a shows a vertical section of the diodes of the present invention. The diodes are fabricated on a nanopaper of Cellulose NanoFibers (CNF) doped with a conductive polymer, as, for example, PEDOT:PSS. This component acts as both the substrate (1) and the bottom electrode-cathode of the diode.

The first layer (2) is a polymeric insulator (amorphous silica, epoxy resin, or crosslinked polyvinylphenol) inkjet-printed onto the conductive nanopaper.

The second layer (3) is of organic p-type semiconductor (OSC), as, for example, the amorphous OSC such as PTAA.

The third layer (4) is the second electrode-anode.

Figure 1b shows an optical image of the diode. The numeration of the layers is the same as the one adopted in Figure 1a.

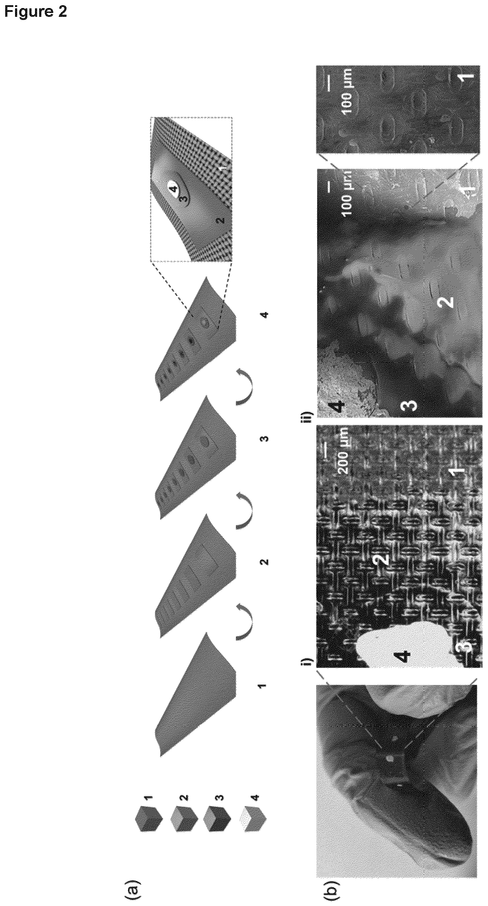

Figure 2a shows the fabrication scheme of the diodes of the present invention.

The first component of the diode to be fabricated is the conductive nanopaper that acts as both the substrate (1) and the bottom electrode-cathode.

The preparation of cellulose nanofibers follows the TEMPO-mediated oxidation at basic pH described in with 5 mmol of NaClO until constant pH of 10. After TEMPO-oxidation, the cellulose suspension is filtered and washed five times with distilled water to remove all non-reacted reagents and free ions. After that, the cellulose suspension at about 1.1 wt% concentration is passed through a high-pressure homogenizer (NS1001L PANDA PLUS 2K_GEA), 3 times at each pressure of 300, 600 and 900 bars.

For the preparation of the conductive nanopaper, the cellulose nanofiber is diluted to about 0.2 wt% concentration with distilled water, dispersed for 30 s by means of an ultra-turrax (IKA, GmbH& Co. KG, Germany) and sonicated, for 10 min at an amplitude of 60% in two equal intervals with a 2 min standby, using a Q700 sonicator.

For the fabrication of conductive nanopapers with PEDOT:PSS as the conductive polymer, the conductive polymer is also diluted with distilled water to about 0.5 wt% and stirred for 5 min. The PEDOT:PSS suspensions is then added into the above CNF suspension with different proportions of CNF-PEDOT:PSS (50/50 and 80/20). The mixture is stirred for 1 h, filtered with a vacuum filter, and dried for 20 min at 85 °C under a pressure of 0.5 - 0.6 bar using a Rapid Köthen sheet dryer.

The first layer (2) of the diode is inkjet printed using a Fujifilm Dimatix DMP2831 desktop inkjet printer. As polymeric insulator of the first layer (2) amorphous silica, epoxy resin, and crosslinked polyvinylphenol has been tested. Polymeric insulator of the first layer (2) is printed onto the conductive nanopaper. Different curing steps can be adopted according to the chosen polymeric insulator (2).

The third layer (3) is an organic p-type semiconductor like the amorphous the organic p-type semiconductor poly(triaryl amine) (PTAA), is deposited on the top of the polymeric insulator of the first layer (2) using drop casting (0.1 µL). The curing process is performed on a hot plate for 2 minutes at 100 °C. The second electrode-anode is the third layer (4), for example, a silver conductive paste deposited by means of drop casting and dried in air.

Figure 2b shows an optical image (i) and a SEM (image (ii) of the diode. The numeration of the layers is the same as the one adopted in Figure 2a.

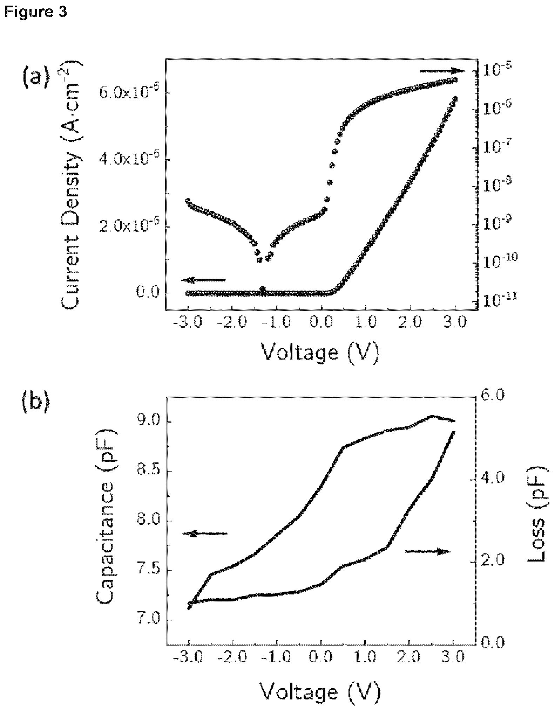

Figure 3 shows the electrical characterization of the diode. Figure 3a shows the typical rectifying behavior of the presented diode. The rectifier barrier is located at the insulator/semiconductor interface.

The Rectification Ratio (RR) is defined as the ratio of the maximum forward bias current to the maximum reverse bias current at the same voltage. The diode reported in Figure 3a presents a RR of 1250.

Figure 3b shows the capacitance-voltage and loss-voltage characteristics of the diode. The loss is defined as the inverse of ωR where ω is the angular frequency and R is the resistance. In Figure 3b, depletion and accumulation region can be distinguished, however, it is possible to notice how the loss keeps increasing as the capacitance increases and fails to saturate. This indicates the presence of a leaky insulator which is confirmed by the impedance characterization: the impedance value passes from 840 MΩ to 510 MΩ in the accumulation regime.

## Claims

1. A diode that comprises:
• a conductive substrate (1) wherein the thickness of said conductive substrate (1) is ranging between 20 µm and 200 µm,
• a first layer (2) comprising a polymeric insulator located on the substrate (1),
wherein the thickness of said first layer (2) is ranging between 500 nm and 1 µm,
• a second layer (3) comprising an organic p-type semiconductor located on the first layer (2),
• a third layer (4) located on the second layer (3),
• wherein the conductive substrate (1) is acting as cathode and the third layer (4) is acting as anode,
**characterized in that**:
• the conductive substrate comprises a conductive nanopaper, said conductive nanopaper comprising:
∘ cellulose nanofibers in a weight percent of between 50 wt% and 80 wt% with respect to the total weight of the conductive substrate (1), and
∘ a conductive material in a weight percent of between 20 wt% and 50 wt% with respect to the total weight of the conductive substrate (1), said conductive material selected from a conductive polymer, carbon nanotubes or a combination thereof,
• the thickness of said second layer (3) is ranging between 200 nm and 500 nm,
• the thickness of said third layer (4) is ranging between 100 nm and 200 nm, and the polymeric insulator of the first layer (2) is a cured ink comprising amorphous silica, epoxy resin and epoxy hardener.

2. The diode according to claim 1, wherein the conductive polymer of the conductive substrate (1) is selected from poly(3,4-ethylenedioxythiophene) polystyrene sulfonate and polypyrrole.

3. The diode according to any of claims 1 or 2, wherein the organic p-type semiconductor of the second layer (3) is poly(triaryl amine).

4. The diode according to any of claims 1 to 3, wherein the third layer (4) is a metal layer, and wherein the metal is selected from Ag and Au.

5. The diode according to any of claims 1 to 3, wherein the third layer (4) is a polymeric layer of poly(3,4-ethylenedioxythiophene) polystyrene sulfonate.

6. The diode according to any of claims 1 to 5 is a diode-logic gate.

7. A process for the manufacturing of a diode according to any of claims 1 to 6, **characterized in that** it comprises the following steps:
a) printing the first layer (2) onto the conductive substrate (1) by means of an additive manufacturing technique,
b) curing the product obtained in step (a),
c) drop casting of the second layer (3) onto the cured product obtained in step (b),
d) curing the product obtained in step (c), and
e) drop casting of the third layer (4) onto the cured product obtained in step (d),
f) drying the product obtained in step (e) in air.

8. The process according to claim 7, wherein the conductive substrate (1) of step (a) is obtained by the following steps:
i) mixing a solution of cellulose nanofibers and a solution of a conductive material selected from a conductive polymer, carbon nanotubes or a combination thereof, wherein the weight percent of the cellulose nanofibers is ranging between 50 wt% and 80 wt% and the weight percent of the conductive material is ranging between 20 wt% and 50 wt% in the final mixture, and
ii) filtering the mixed solution obtained in step (i) under vacuum at a pressure ranging from 0.1 bar to 0.9 bar and at a temperature between 30 °C and 100 °C.

9. The process according to any of claims 7 or 8, wherein step (a) is performed by means of inkjet printing.

10. The process according to any of claims 7 to 9, wherein steps (b) and (d) are performed by means of a hot plate independently.

11. Electronic component comprising the diode according to any of claims 1 to 6.

## Patentansprüche

1. Diode, die Folgendes umfasst:
• ein leitfähiges Substrat (1), wobei die Dicke des leitfähigen Substrats (1) zwischen 20 µm und 200 µm liegt,
• eine erste Schicht (2), umfassend einen Polymerisolator, die sich auf dem Substrat (1) befindet,
wobei die Dicke der ersten Schicht (2) zwischen 500 nm und 1 µm liegt,
• eine zweite Schicht (3), umfassend einen organischen Halbleiter vom p-Typ, der sich auf der ersten Schicht (2) befindet,
• eine dritte Schicht (4), die sich auf der zweiten Schicht (3) befindet,
• wobei das leitfähige Substrat (1) als Kathode und die dritte Schicht (4) als Anode fungiert,
**dadurch gekennzeichnet, dass**:
• das leitfähige Substrat ein leitfähiges Nanopapier umfasst, wobei das leitfähige Nanopapier Folgendes umfasst:
∘ Zellulose-Nanofasern in einem Gewichtsprozentanteil zwischen 50 Gew.-% und 80 Gew.-%, bezogen auf das Gesamtgewicht des leitfähigen Substrats (1), und
∘ ein leitfähiges Material in einem Gewichtsprozentanteil zwischen 20 Gew.-% und 50 Gew.-%, bezogen auf das Gesamtgewicht des leitfähigen Substrats (1), wobei das leitfähige Material aus einem leitfähigen Polymer, Kohlenstoff-Nanoröhren oder einer Kombination davon ausgewählt ist,
• die Dicke der zweiten Schicht (3) zwischen 200 nm und 500 nm liegt,
• die Dicke der dritten Schicht (4) zwischen 100 nm und 200 nm liegt und
der Polymerisolator der ersten Schicht (2) eine gehärtete Tinte, die amorphes Siliziumdioxid, Epoxidharz und Epoxidhärter umfasst, ist.

2. Diode nach Anspruch 1, wobei das leitfähige Polymer des leitfähigen Substrats (1) aus Poly(3,4-ethylendioxythiophen), Polystyrolsulfonat und Polypyrrol ausgewählt ist.

3. Diode nach einem der Ansprüche 1 oder 2, wobei der organische Halbleiter vom p-Typ der zweiten Schicht (3) Poly(triarylamin) ist.

4. Diode nach einem der Ansprüche 1 bis 3, wobei die dritte Schicht (4) eine Metallschicht ist und wobei das Metall aus Ag und Au ausgewählt ist.

5. Diode nach einem der Ansprüche 1 bis 3, wobei die dritte Schicht (4) eine Polymerschicht aus Poly(3,4-ethylendioxythiophen)polystyrolsulfonat ist.

6. Diode nach einem der Ansprüche 1 bis 5, die ein Dioden-Logik-Gatter ist.

7. Verfahren zur Herstellung einer Diode nach einem der Ansprüche 1 bis 6, **dadurch gekennzeichnet, dass** es die folgenden Schritte umfasst:
a) Aufdrucken der ersten Schicht (2) auf das leitfähige Substrat (1) mittels einer additiven Fertigungstechnik,
b) Aushärten des in Schritt (a) erhaltenen Produkts,
c) Tropfbeschichten des in Schritt (b) erhaltenen gehärteten Produkts mit der zweiten Schicht (3),
d) Aushärten des in Schritt (c) erhaltenen Produkts und
e) Tropfbeschichten des in Schritt (d) erhaltenen gehärteten Produkts mit der dritten Schicht (4),
f) Trocknen des in Schritt (e) erhaltenen Produkts an der Luft.

8. Verfahren nach Anspruch 7, wobei das leitfähige Substrat (1) von Schritt (a) durch die folgenden Schritte erhalten wird:
i) Mischen einer Lösung von Zellulose-Nanofasern und einer Lösung eines leitfähigen Materials, ausgewählt aus einem leitfähigen Polymer, Kohlenstoff-Nanoröhrchen oder einer Kombination davon, wobei der Gewichtsprozentanteil der Zellulose-Nanofasern zwischen 50 Gew.-% und 80 Gew.-% und der Gewichtsprozentanteil des leitfähigen Materials zwischen 20 Gew.-% und 50 Gew.-% in der Endmischung liegt, und
ii) Filtrieren der in Schritt (i) erhaltenen gemischten Lösung unter Vakuum bei einem Druck von 0,1 bar bis 0,9 bar und bei einer Temperatur zwischen 30 °C und 100 °C.

9. Verfahren nach einem der Ansprüche 7 oder 8, wobei Schritt (a) mittels Tintenstrahldruck durchgeführt wird.

10. Verfahren nach einem der Ansprüche 7 bis 9, wobei die Schritte (b) und (d) unabhängig mit Hilfe einer Heizplatte durchgeführt werden.

11. Elektronisches Bauteil, das die Diode nach einem der Ansprüche 1 bis 6 umfasst.

## Revendications

1. Diode qui comprend :
• un substrat conducteur (1) dans laquelle l'épaisseur dudit substrat conducteur (1) est comprise entre 20 µm et 200 µm,
• une première couche (2) comprenant un isolant polymère situé sur le substrat (1),
dans laquelle l'épaisseur de ladite première couche (2) est comprise entre 500 nm et 1 µm,
• une deuxième couche (3) comprenant un semi-conducteur organique de type p situé sur la première couche (2),
• une troisième couche (4) située sur la deuxième couche (3),
• dans laquelle le substrat conducteur (1) agit en guise de cathode et la troisième couche (4) agit en guise d'anode,
**caractérisée en ce que** :
• le substrat conducteur comprend un nanopapier conducteur, ledit nanopapier conducteur comprenant :
∘ des nanofibres de cellulose dans un pourcentage en poids entre 50 % en poids et 80 % en poids par rapport au poids total du substrat conducteur (1), et
∘ un matériau conducteur dans un pourcentage en poids entre 20 % en poids et 50 % en poids par rapport au poids total du substrat conducteur (1), ledit matériau conducteur étant choisi parmi un polymère conducteur, des nanotubes de carbone ou une combinaison de ceux-ci,
• l'épaisseur de ladite deuxième couche (3) est comprise entre 200 nm et 500 nm,
• l'épaisseur de ladite troisième couche (4) est comprise entre 100 nm et 200 nm, et
l'isolant polymère de la première couche (2) est une encre durcie comprenant de la silice amorphe, de la résine époxy et un durcisseur époxy.

2. Diode selon la revendication 1, dans lequel le polymère conducteur du substrat conducteur (1) est choisi parmi le poly(3,4-ethylenedioxythiophene)-poly(styrenesulfonate) et le polypyrrole.

3. Diode selon l'une quelconque des revendications 1 ou 2, dans laquelle le semi-conducteur organique de type p de la deuxième couche (3) est le poly(triarylamine).

4. Diode selon l'une quelconque des revendications 1 à 3, dans laquelle la troisième couche (4) est une couche métallique, et dans laquelle le métal est choisi parmi Ag et Au.

5. Diode selon l'une quelconque des revendications 1 à 3, dans laquelle la troisième couche (4) est une couche polymère de poly(3,4-ethylenedioxythiophene)-poly(styrenesulfonate).

6. Diode selon l'une quelconque des revendications 1 à 5 est une porte de logique à diodes.

7. Procédé de fabrication d'une diode selon l'une quelconque des revendications 1 à 6, **caractérisé en ce qu'**il comprend les étapes suivantes :
a) impression de la première couche (2) sur le substrat conducteur (1) au moyen d'une technique de fabrication additive,
b) durcissement du produit obtenu à l'étape a),
c) dépôt à la goutte de la deuxième couche (3) sur le produit durci obtenu à l'étape b),
d) durcissement du produit obtenu à l'étape c), et
e) dépôt à la goutte de la troisième couche (4) sur le produit durci obtenu à l'étape d),
f) séchage à l'air du produit obtenu à l'étape e).

8. Procédé selon la revendication 7, le substrat conducteur (1) de l'étape (a) est obtenu par les étapes suivantes :
i) mélange d'une solution de nanofibres de cellulose et d'une solution d'un matériau conducteur choisi parmi un polymère conducteur, des nanotubes de carbone ou une combinaison de ceux-ci, dans lequel le pourcentage en poids des nanofibres de cellulose est compris entre 50 % en poids et 80 % en poids et le pourcentage en poids du matériau conducteur est compris entre 20 % en poids et 50 % en poids dans le mélange final, et
ii) filtrage de la solution mélangée obtenue à l'étape i) sous vide à une pression comprise entre 0,1 bar et 0,9 bar et à une température entre 30 °C et 100 °C.

9. Procédé selon l'une quelconque des revendications 7 ou 8, dans lequel l'étape (a) est réalisée au moyen d'une impression à jet d'encre.

10. Procédé selon l'une quelconque des revendications 7 à 9, dans lequel les étapes (b) et (d) sont réalisées indépendamment au moyen d'une plaque chauffante.

11. Composant électronique comprenant la diode selon l'une quelconque des revendications 1 à 6.
